## Europäisches Patentamt
## European Patent Office
## Office européen des brevets

(19)

(11) Veröffentlichungsnummer: **0 220 196**
**B1**

(12) **EUROPÄISCHE PATENTSCHRIFT**

(45) Veröffentlichungstag der Patentschrift:
**13.07.88**

(51) Int. Cl.⁴: **B 60 R 16/02**; H 05 K 7/02

(21) Anmeldenummer: **86900744.3**

(22) Anmeldetag: **28.01.86**

(86) Internationale Anmeldenummer:
**PCT/DE 86/00028**

(87) Internationale Veröffentlichungsnummer:
**WO 86/06334 (06.11.86 Gazette 86/24)**

(54) **GEHÄUSE ZUR AUFNAHME ELEKTRISCHER STEUERGERÄTE, INSBESONDERE FÜR KRAFTFAHRZEUGE.**

(30) Priorität: **20.04.85 DE 3514440**

(43) Veröffentlichungstag der Anmeldung:
**06.05.87 Patentblatt 87/19**

(45) Bekanntmachung des Hinweises auf die Patenterteilung:
**13.07.88 Patentblatt 88/28**

(84) Benannte Vertragsstaaten:
**DE FR GB SE**

(56) Entgegenhaltungen:
**DE - A - 2 409 660**
**FR - A - 2 204 943**
**US - A - 4 172 272**

(73) Patentinhaber: **ROBERT BOSCH GMBH, Postfach 50, D-7000 Stuttgart 1 (DE)**

(72) Erfinder: **BENTZ, Willy, Alte Grossachsenheimer Strasse 3, D-7123 Sachsenheim (DE)**
Erfinder: **GANSERT, Willi, Geschwister-Scholl-Strasse 34, D-7014 Kornwestheim (DE)**

ACTORUM AG

## Beschreibung

### Stand der Technik

Die Erfindung betrifft eine Gehäuse zur Aufnahme von elektrischen Steuergeräten, insbesondere für Kraftfahrzeuge, das mit einem Deckel verschliessbar ist und in dem eine zentrale Anschlussplatte angeordnet ist, die mit Leiterbahnen und lösbaren Verbindungsmitteln sowohl für Spannungsversorgung und Signalgeber als auch für jedes elektrische Steuergerät versehen ist, welche Steuergeräte Verbindungsmittel zum lösbaren Anschluss an die zentrale Anschlussplatte und zum lösbaren Verbinden mit einem die Ausgangssignale der Steuergeräte an zusteuernde Aggregate leitenden Kabelbaum aufweisen, wobei alle Verbindungsmittel im geschlossenen Gehäuse untergebracht sind.

Es ist bereits ein solches Gehäuse bekannt, z. B. aus dem Dokument DE-A-2409660, in dem alle im Motorraum des Kraftfahrzeugs unterzubringenden elektrischen Steuergeräte derart angeordnet sind, dass sie mit zahlreichen zusätzlichen Teilen angeschraubt werden müssen. Dabei ist jedoch von Nachteil, dass das Ableiten der Verlustwärme von den im engen Gehäuse untergebrachten Steuergeräten durch den Widerstand an den vielen Wärmeübergangsstellen behindert wird und die somit nicht ausreichend gekühlten Steuergeräte durch Wärmeeinflüsse in kurzer Zeit nicht mehr funktionsfähig sind. Ausserdem ist bei der Vielzahl der im Gehäuse untergebrachten Steuergeräte nicht sichergestellt, dass im Montage- oder Servicefall jedes der Steuergeräte verlustwärmeableitend im Gehäuse befestigt ist.

### Aufgabe, Lösung und Vorteile der Erfindung

Der Erfindung liegt die Aufgabe zugrunde, ein Gehäuse zur Aufnahme verschiedener elektrischer Steuergeräte, insbesondere für Kraftfahrzeuge, beispielsweise für Antiblockiersystem, Getriebesteuerung, Motorelektronik, Zündsystem zu schaffen, bei dem ermöglicht wird, jedes Steuergerät zur Ableitung der Verlustwärme grossflächig direkt an das Gehäuse leicht lösbar zu koppeln und das mit einfachen Mitteln zu versehen ist, die eine sichere Befestigung und Verlustwärmeableitung für die Steuergeräte gewährleisten.

Zur Lösung dieser Aufgabe sind die im Hauptanspruch angegebenen Massnahmen vorgesehen.

Dabei ist von Vorteil, dass die elektrischen Steuergeräte direkt mit ihrer Grundplatte grossflächig an das Gehäuse gedrückt werden mittels einer einfachen Klemm- oder Verriegelungsvorrichtung für jedes Steuergerät oder einer gemeinsamen Vorrichtung für alle Steuergeräte, wobei diese Vorrichtung oder Vorrichtungen so ausgebildet sind, dass nur wenn alle im Gehäuse untergebrachten Steuergeräte vorschriftsmässig eingesetzt und an das Gehäuse gedrückt sind, das Gehäuse mit dem Deckel verschlossen werden kann.

Durch die in den Unteransprüchen aufgeführten Massnahmen sind vorteilhafte Weiterbildungen des im Hauptanspruch angegebenen Gehäuses möglich. Besonders vorteilhaft sind die direkte isolierte oder nicht isolierte Anordnung der zu kühlenden Bauelemente auf der als Kühlteil wirkenden Grundplatte. Darüber hinaus sind die als Montagesicherung vorgesehenen federnden Toleranzausgleichsmittel direkt in die Klemm- und Verriegelungsvorrichtung integriert, so dass bei mangelhaftem Anordnen eines Steuergerätes im Gehäuse und somit schlechter Kühlung dieses Geräts der Deckel das Gehäuse nicht dicht verschliessen kann.

### Zeichnung

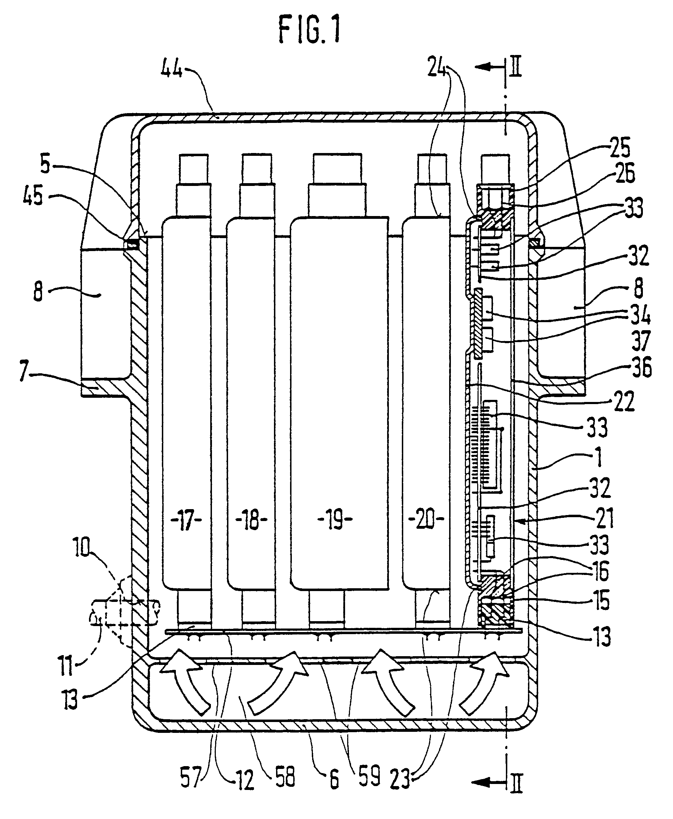

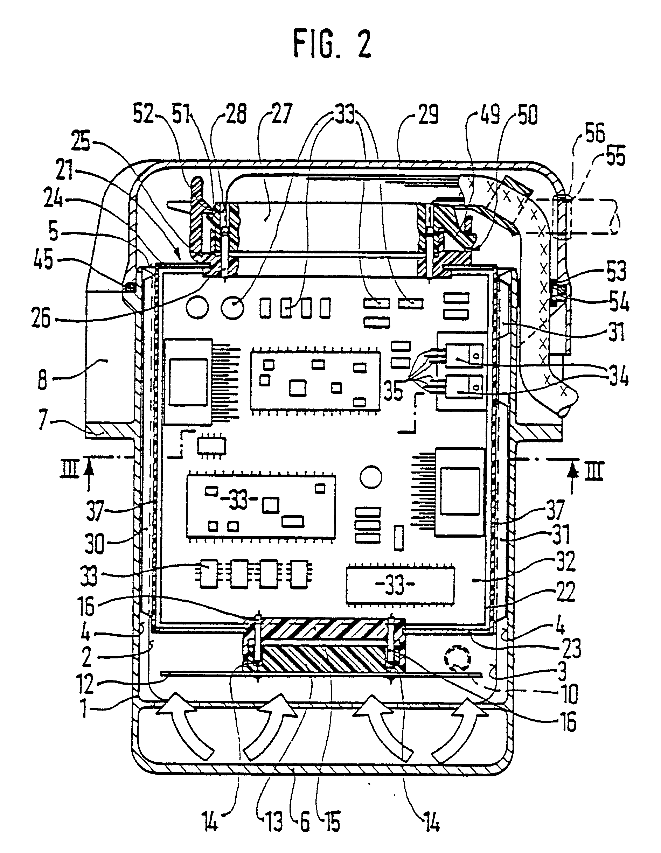

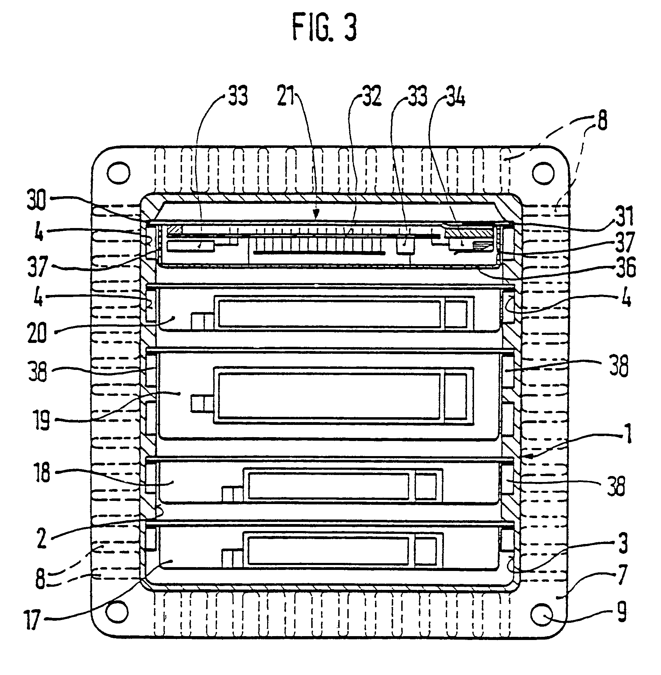

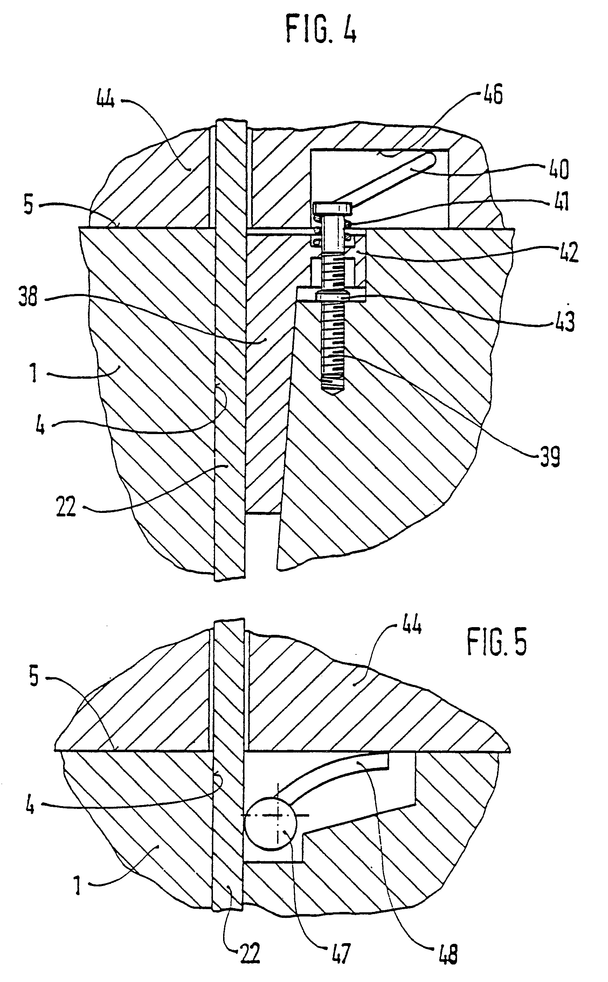

Ein Ausführungsbeispiel der Erfindung ist in der Zeichnung dargestellt und in der nachfolgenden Beschreibung näher erläutert. Es zeigen Figur 1 ein Gehäuse mit fünf Steuergeräten in Modularanordnung, teilweise im Längsschnitt, Figur 2 einen Schnitt durch das Gehäuse entlang der Linie II-II in Figur 1, Figur 3 einen Schnitt durch das Gehäuse entlang der Linie III-III in Figur 2, Figur 4 einen Teilschnitt des Gehäuses mit einer Klemm- und Verriegelungsvorrichtung und Figur 5 eine Abwandlung der Vorrichtung nach Figur 4.

### Beschreibung des Ausführungsbeispieles

Ein Gehäuse 1 beispielsweise aus Leichtmetall ist im wesentlichen kastenförmig mit rechteckigem Querschnitt ausgebildet. In zwei gegenüberliegenden Innenwänden 2 und 3 sind Führungsnuten 4 eingeformt, die von der Stirnseite 5 an der offenen Seite des Gehäuses 1 zu dessen Boden 6 hin parallel verlaufen.

Das Gehäuse 1 ist aussen mit einem parallel zur Stirnseite 5 umlaufenden Flansch 7 versehen, an dem Kühlrippen 8 angeformt und Befestigungslöcher 9 zum Befestigen des Gehäuses 1 an der Karosserie des Kraftfahrzeugs ausgebildet sind. Ausserdem hat das Gehäuse 1 eine Öffnung 10 zum abgedichteten Einführen von Leitungen 11 zur Spannungsversorgung und für den Signalgeberanschluss.

Im Gehäuse 1 ist eine zentrale Anschlussplatte 12 parallel zum Boden 6 angeordnet. Die Anschlussplatte 12 ist beispielsweise eine Leiterplatte und trägt an sich bekannte und nicht näher dargestellte Leiterbahnen und parallel zueinander sitzende Steckerleisten 13 mit Steckhülsen 14. Die Steckhülsen 14 sind über zugehörige Leiterbahnen an die Spannungsversorgung und an zugeordnete Signalgeber angeschlossen und soweit erforderlich mit Steckhülsen 14 anderer Steckerleisten 13 verbunden. Die Steckerleisten 13 gehören zu ersten lösbaren Verbindungsvorrichtungen, deren zugeordnete Gegenstecker 15 mit Steckerstiften oder Flachsteckern 16 an elektrischen Steuergeräten 17, 18, 19, 20, 21 angeordnet sind. Über die ersten Verbindungsvorrichtungen 13 bis 16 sind somit die Steuergeräte 17 bis 21 an die Versorgungsspannung, die zugeordneten Signalgeber und Anzeigegeräte am Armaturenbrett anschliessbar und falls erforderlich untereinander lösbar verbunden.

Jedes Steuergerät 17 bis 21 hat eine Grundplatte 22, die zugleich als Kühlteil dient. Die Grundplatte 22 hat an zwei gegenüberliegenden Seiten jeweils einen etwa rechtwinklig angeformten Rand 23 oder 24. Im Rand 23 ist der Gegenstecker 16 angeordnet. Im Rand 24 ist eine Steckerleiste 25 einer zweiten lösbaren Verbindungsvorrichtung mit Steckerstiften oder Flachsteckern 26 angeordnet. Die zugehörigen Gegenstecker 27 sind mit Steckhülsen 28 versehen, welche an Leitungen 29 angeschlagen sind. Die Leitungen 29 sind an nicht näher dargestellte, an sich bekannte zu steuernde Aggregate angeschlossen, zu denen sie die Ausgangssignale der zugeordneten Steuergeräte 17 bis 21 leiten. Die Leitungen 29 sind dafür zu einem modulartig aufgebauten Kabelbaum zusammengefasst.

An den beiden anderen einander gegenüberliegenden Seiten der Grundplatte 22 ist jeweils ein in einer Ebene parallel zur Grundplatte 22 liegender Führungsrand 30 oder 31 ausgebildet. Der Führungsrand 30 oder 31 kann auch aus mehreren Lappen bestehen.

Jedes Steuergerät 17 bis 21 hat mindestens eine Leiterplatte 32, auf der diskrete und/oder integrierte Bauelemente 33 angeordnet sind. Die Bauelemente 33 sind in an sich bekannter und nicht näher dargestellter Weise mit ebenfalls nicht dargestellten Leiterbahnen auf der Leiterplatte 32 verbunden. Zu kühlende Bauelemente 34 sind direkt auf der Grundplatte 22 angeordnet, während die Anschlusselektroden 35 dieser Bauelemente 34 ebenfalls mit zugeordneten Leiterbahnen der Leiterplatte 32 verbunden sind. Die zu kühlenden Bauelemente 34 können isoliert oder unisoliert auf der Grundplatte 22 befestigt sein.

Jedes Steuergerät 17 bis 21 ist mit einem Deckel 36 verschlossen, um mechanische Beschädigungen auszuschliessen, die beim getrennten Ein- und Ausbauen der einzelnen Steuergeräte entstehen könnten. Der Deckel 36 ist im wesentlichen plattenförmig ausgebildet und besitzt an zwei gegenüberliegenden Seiten je einen rechtwinklig angeformten Lappen 37. Zum Verschliessen des Steuergeräts 17, 18, 19, 20 oder 21 ist der Deckel 36 auf die den Gegenstecker 15 und die Steckerleiste 25 aufnehmenden Ränder 23 und 24 sowie auf Gegenstecker 15 und Steckerleiste 25 gelegt, wobei die Lappen 37 an die Innenseite der Führungsränder 30, 31 der Grundplatte 22 ragen.

Nachdem jedes Steuergerät 17 bis 21 für sich montiert, geprüft, abgeglichen und verschlossen ist, wird es in das Gehäuse 1 geschoben und sein Gegenstecker 15 auf die zugehörige Steckerleiste 13 auf der zentralen Anschlussplatte 12 gesteckt. Die Führungsränder 30 und 31 der Grundplatte 22 werden dabei in den zugeordneten Führungsnuten 4 des Gehäuses 1 aufgenommen. Die Wärmeableitung für die auf der Grundplatte 22 angeordneten Bauelemente 34 erfolgt über die Grundplatte 22 auf das Gehäuse 1 und wenn weiter erforderlich auf die Karosserie des Kraftfahrzeugs, in welches das Gehäuse 1 mit den Steuergeräten 17 bis 21 eingebaut ist. Zum besseren Wärmeübergang von den Führungsrändern 30, 31 der Grundplatte 22 zum Gehäuse 1 ist in die Führungsnuten 4 jeweils ein Keil 38 einer Klemm- und Verriegelungsvorrichtung (Figur 4) eingebracht, der den zugeordneten Führungsrand 30 oder 31 fest an die Führungsnut 4 drückt, um den Wärmeübergang zum Gehäuse 1 zu erleichtern und eine grossflächige Wärmeableitung an beiden Seiten der Grundplatte 22 zu ermöglichen. Der Keil 38 wird dabei durch eine Bundschraube 39 in die Ausnehmung 4 gedrückt. Die Bundschraube 39 ist beispielsweise mit einem Gewinde mit grosser Steigung oder einem Bajonettverschluss in das Gehäuse 1 geschraubt. Ausserdem ist am Kopf der Bundschraube 39 ein Sicherungshebel 40 befestigt. Auf der Bundschraube 39 sitzt noch eine Druckfeder 41. Sie liegt mit einem Ende am Kopf der Bundschraube 39 an und stützt sich mit dem anderen Ende am einen Vorsprung 42 des Keils 38 ab, durch den die Bundschraube 39 ragt. Ein Sicherungsring 43 sitzt auf der Bundschraube 39 zwischen dem Vorsprung 42 des Keils 38 und dem Gehäuse 1 und ermöglicht das Abziehen des Keils 38 aus der Führungsnut 4 zum Lösen der Grundplatte 22. Die Druckfeder 41 dient zum Toleranzausgleich zwischen Gehäuse 1, 4, eingeschobenem Steuergerät mit Grundplatte 22 und einem Deckel 44, der das die Steuergeräte 17 bis 21 aufnehmende Gehäuse 1 abdichtend verschliesst. Zwischen Gehäusestirnseite 5 und Deckel 44 ist noch ein Dichtring 45 (Figuren 1 und 2) angeordnet. Der Sicherungshebel 40 ragt in eine Ausnehmung 46 des Deckels 44. Erst wenn die Bundschraube 39 in erforderlichem Masse angezogen ist und somit die gewünschte Kühlwirkung erreicht werden kann, lässt sich der Deckel 44 montieren. Der Sicherungshebel 40 lässt sich auch als Zentralverriegelung für alle im Gehäuse 1 angeordneten Steuergeräte 17 bis 21 ausbilden.

In einer Abwandlung der Klemm- und Verriegelungsvorrichtung nach Figur 5 ist ein Exzenter 47 im Gehäuse 1 drehbar angeordnet. Es ist gegen die Grundplatte 22 eines der Steuergeräte 17 bis 21 mittels eines Bedienungshebels 48 drückbar. Dadurch wird der Führungsrand 30 oder 31 der Grundplatte 22 in der Führungsnut 4 fest an das Gehäuse 1 gedrückt. Der Bedienungshebel 48 ist federnd ausgebildet und liegt am Deckel 44 an. Dadurch hält der Deckel 44 den Bedienungshebel 48 toleranzausgleichend im Gehäuse 1 und den Exzenter 47 in seiner Andrückstellung. Der Deckel 44 ist jeweils in an sich bekannter und nicht näher dargestellter Weise, beispielsweise mittels Schrauben am Gehäuse 1 lösbar befestigt.

Je nach der Art und Anzahl der benötigten Steuergeräte 17 bis 21 — beispielsweise für Motronic, Antiblockiersystem, Getriebesteuerung, Zündsystem — sind die Leistungen 29 zu einem modulartig aufgebauten Kabelbaum zusammengefasst. Die Gegenstecker 27 der zweiten Verbindungsvorrichtung können dabei ebenfalls zu einem Modulstecker vereinigt werden. Die Gegenstecker 27 sind jeweils mit einem Befestigungshaken 49 versehen, welcher in eine Öffnung 50 der zugeordneten Steckerleiste 25 greift. Ausserdem weisen die Gegenstecker 27 einen Rasthaken 51 auf, der bei eingestecktem Gegenstecker 27 hinter einem zum Lösen wegschwenkbaren Verriegelungshebel 52 der Steckerleiste 25 einrastet. An sich bekannte und nicht näher dargestellte Codiermittel ermöglichen nur das Verbinden eines Gegensteckers 27 mit der zugeordneten Steckerleiste 25 eines der Steuergeräte 17 bis 21. Die zu dem Modulstecker zusammengefassten Gegenstecker 27 sind innerhalb des mit dem Deckel 44 abdichtend verschlossenen Gehäuses 1 untergebracht. Der modulartig aufgebaute Kabelbaum aus den Leitungen 29 ist abgedichtet mittels eines Dichtteils 53 durch eine Öffnung 54 des Gehäuses 1 zu den zu steuernden Aggregaten geführt. Der Kabelbaum kann auch durch eine Bohrung 55 des Deckels 44, in der ein Dichtring 56 sitzt, abgedichtet aus dem Gehäuse 1 geführt sein.

Kann das Gehäuse 1 mit den Steuergeräten 17 bis 21 nur an einer Stelle im Kraftfahrzeug eingebaut werden, deren Umgebungstemperatur eine weitere Kühlung erfordert, kann diese Kühlung durch eine Zwangskonvektion innerhalb des Gehäuses 1 erfolgen. Dazu ist beispielsweise im Gehäuse 1 zwischen Boden 7 und Anschlussplatte 12 ein Zwischenboden 57 angeformt, der einen Aufnahmeraum 58 beispielsweise für ein an sich bekanntes und nicht näher dargestelltes Gebläse begrenzt. Der Zwischenboden 57 ist mit Öffnungen 59 versehen, durch welche die Kühlluft für die Steuergeräte 17 bis 21 zirkulieren kann. Bei günstigeren Einbaumöglichkeiten kann auch die dem Fahrtwind ausgesetzte Luft im Aufnahmeraum 58 zum Kühlen der Luft im Gehäuse 1 und somit der Steuergeräte 17 bis 21 ausreichen. Der Zwischenboden 57 ist dann ohne die Öffnungen 59 ausgeführt.

In dem an beliebiger Stelle im Kraftfahrzeug anbaubaren Gehäuse 1 ist die gesamte Fahrzeugelektronik untergebracht in Form aller elektrischen Steuergeräte 17 bis 21 samt ihren ersten lösbaren Verbindungsmitteln 13 bis 16 und der gemeinsamen Anschlussplatte 12 einerseits sowie ihren zweiten modulartig zusammengefassten, einzeln lösbaren zweiten Verbindungsmitteln 25 bis 28. Die Eingangssignale können somit auf einfache Weise über die Anschlussplatte 12 zu den einzelnen Steuergeräten 17 bis 21 geleitet werden. Die Signalübertragung zwischen den einzelnen Steuergeräten 17 bis 21 ist über die Anschlussplatte 12 auf kürzestem Wege möglich. Dadurch können weniger Störeinflüsse zumindest von aussen wirksam werden, so dass die elektromagnetische Verträglichkeit der Fahrzeugelektronik erhöht wird.

Durch die zu einem Modulstecker zusammenfassbaren Gegenstecker 27 lässt sich auch der aus den Leitungen 29 gebildete Kabelbaum modulartig je nach Art der im Gehäuse 1 angeordneten Steuergeräte 17 bis 21 aufbauen.

Die Verbindung der einzelnen Steuergeräte 17 bis 21 mit dem Gehäuse 1 durch die in die Führungsnuten 4 des Gehäuses 1 eingeschobenen und dort fest angedrückten Führungsränder 30 und 31 der Grundplatte 22 der einzelnen Steuergeräte 17 bis 21 mittels einer Klemm- und Verriegelungsvorrichtung 38 bis 44 oder 47, 48 ist eine grossflächige Wärmeableitung beidseitig der Grundplatte 22 jedes Steuergeräts 17 bis 21 ermöglicht.

## Patentansprüche

1. Gehäuse (1) zur Aufnahme elektrischer Steuergeräte (17, 18, 19, 20, 21), insbesondere für Kraftfahrzeuge, das mit einem Deckel (44) dicht verschliessbar ist und in dem eine zentrale Anschlussplatte (12) angeordnet ist, die mit Leiterbahnen und lösbaren Verbindungsmitteln (16, 26) sowohl für Spannungsversorgung und Signalgeber als auch für jedes elektrische Steuergerät versehen ist, welche Steuergeräte Verbindungsmittel zum lösbaren Anschluss an die zentrale Anschlussplatte und zum lösbaren Verbinden mit einem die Ausgangssignale der Steuergeräte an zusteuernde Aggregate leitenden Kabelbaum aufweisen, wobei alle Verbindungsmittel im geschlossenen Gehäuse untergebracht sind, dadurch gekennzeichnet, dass jedes Steuergerät (17 bis 21) mit einer als Kühlteil ausgebildeten Grundplatte (22) versehen ist, welche in Ausnehmungen (4) des Gehäuses (1) einschiebbar ist, und mindestens eine die Grundplatten (22) dicht an Verlustwärmeableitflächen haltende Vorrichtung (38 bis 40; 47, 48) im Gehäuse (1) untergebracht ist, in deren gelöster Stellung das Gehäuse (1) nicht mit dem Deckel (44) verschliessbar ist.

2. Gehäuse nach Anspruch 1, dadurch gekennzeichnet, dass zu kühlende Bauelemente (34) direkt unisoliert oder isoliert auf der Grundplatte (22) der Steuergeräte (17 bis 21) angeordnet sind.

3. Gehäuse nach Anspruch 1, dadurch gekennzeichnet, dass die Grundplatte (22) mittels einer lösbaren Klemmvorrichtung (38 bis 40; 47, 48) beidseitig in einer Ausnehmung (4) des Gehäuses (1) an Verlustwärmeableitflächen andrückbar ist.

4. Gehäuse nach Anspruch 1, dadurch gekennzeichnet, dass eine die Grundplatten (22) aller Steuergeräte (17 bis 21) beidseitig in den Ausnehmungen (4) des Gehäuses (1) an Verlustwärmeableitflächen des Gehäuses (1) andrückende Klemmvorrichtung (38 bis 40; 47, 48) als Zentralverriegelung ausgebildet ist.

5. Gehäuse nach Anspruch 1, dadurch gekennzeichnet, dass zwischen Gehäuse (1) und Deckel (44) eine toleranzausgleichende Federvorrichtung (41; 48) angeordnet ist.

6. Gehäuse nach Anspruch 1, dadurch gekennzeichnet, dass die Federvorrichtung (41; 48) in die die Grundplatten (22) dicht an die Verlustwärmeableitflächen haltende Vorrichtung (38 bis 40; 47, 48) integriert ist.

## Claims

1. Housing (1) for accommodating electric control devices (17, 18, 19, 20, 21), particularly for motor vehicles, which can be tightly closed by means of a cover (44) and in which a central connecting board (12) is arranged which is provided with conductor tracks and detachable connecting means (16, 26) both for voltage supply and signal transmitters and for each electric control device, which control devices exhibit connecting means for detachable connection to the central connecting board and for detachable connection to a cable tree conducting the output signals of the control devices to units to be controlled, all connecting means being accommodated in the closed housing, characterized in that each control device (17 to 21) is provided with a baseplate (22) which is constructed as cooling part and which can be inserted into recesses (4) of the housing (1), and at least one device (38 to 40; 47, 48), holding the baseplates (22) closely against dissipation heat removing areas, is accommodated in the housing (1) in the detached position of which device the housing (1) cannot be closed by means of the cover (44).

2. Housing according to Claim 1, characterized in that components (34) to be cooled are directly arranged uninsulated or insulated on the baseplate (22) of the control devices (17 to 21).

3. Housing according to Claim 1, characterized in that the baseplate (22) can be pressed against dissipation heat removing areas on both sides in a recess (4) of the housing (1) by means of a detachable clamping device (38 to 40; 47, 48).

4. Housing according to Claim 1, characterized in that a clamping device (38 to 40; 47, 48), which presses the baseplate (22) of all control devices (17 to 21) against dissipation heat removing areas of the housing (1) on both sides in the recesses (4) of the housing (1), is designed as a central locking device.

5. Housing according to Claim 1, characterized in that a tolerance-compensating spring device (41; 48) is arranged between housing (1) and cover (44).

6. Housing according to Claim 1, characterized in that the spring device (41; 48) is integrated into the device (38 to 40; 47, 48) which holds the baseplates (22) closely against the dissipation heat removing areas.

## Revendications

1. Réceptacle (1) d'appareillage électrique de commande, notamment pour des véhicules automobiles, qui est susceptible d'être fermé de façon étanche par un couvercle (44) et dans lequel est disposée une plaque de raccordement centrale (12), qui est munie de pistes conductrices et de moyens de liaison amovibles (16, 26) aussi bien pour l'alimentation en tension et l'émetteur de signaux, qu'également pour chaque appareil électrique de commande, ces appareils de commande comportant un moyen de liaison pour leur raccordement amovible à la plaque de raccordement centrale et pour leur liaison amovible avec un faisceau de câbles acheminant les signaux de sortie des appareils de commande aux équipements à commander, tous ces moyens de liaison étant logés dans le réceptacle fermé, réceptacle caractérisé en ce que chaque appareil de commande (17 à 21) est muni d'une plaque de base (22) constituant une pièce de refroidissement qui est susceptible d'être insérée dans des évidements (4) du réceptacle (1), et au moins un dispositif (38 à 40; 47, 48) maintenant étroitement les plaques de base (22) contre des surfaces d'évacuation de la chaleur perdue, est logé dans le réceptacle, le réceptacle ne pouvant être fermé par son couvercle (44) lorsque ce dispositif est déclenché.

2. Réceptacle selon la revendication 1, caractérisé en ce que les éléments constitutifs (34) à refroidir sont disposés directement, sans être isolés ou bien en étant isolés, sur la plaque de base (22) des appareils de commande (17 à 21).

3. Réceptacle selon la revendication 1, caractérisé en ce que la plaque de base (22) est susceptible d'être pressée contre les surfaces d'évacuation de la chaleur perdue, pressée contre les surfaces d'évacuation de la chaleur perdue, des deux côtés, dans un évidement (4) du réceptacle (1) par un dispositif de serrage amovible (38 à 40; 47, 48).

4. Réceptacle selon la revendication 1, caractérisé en ce qu'un dispositif de serrage (38 à 40; 47, 48) pressant les plaques de base (22) de tous les appareils de commande (17 à 21), des deux côtés dans les évidements (4) du réceptacle (1), contre les surfaces d'évacuation de la chaleur perdue, est réalisé sous la forme d'un verrouillage central.

5. Réceptacle selon la revendication 1, caractérisé en ce qu'un dispositif élastique (41; 48) compensant les tolérances est disposé entre le réceptacle (1) et le couvercle (44).

6. Réceptacle selon la revendication 1, caractérisé en ce que le dispositif élastique (41; 48) est intégré dans le dispositif (38 à 40; 47, 48) maintenant étroitement les plaques de base (22) contre les surfaces d'évacuation de la chaleur perdue.

FIG.1

# FIG. 2

# FIG. 3

# FIG. 4

# FIG. 5